# EUROPÄISCHE PATENTSCHRIFT

(11) **EP 0 596 584 B1**
(45) Veröffentlichungstag und Bekanntmachung des Hinweises auf die Patenterteilung: **17.03.1999**
(21) Anmeldenummer: 93250297.4
(22) Anmeldetag: 03.11.1993
(51) Int. Cl.: G01R 31/312, G01R 31/315, G06F 11/00

(54) **Einrichtung zur Störungserfassung**
Disturbance registration arrangement
Arrangement de saisie de perturbation

(30) Priorität: 04.11.1992 DE 4237828
(43) Veröffentlichungstag der Anmeldung: 11.05.1994
(73) Patentinhaber: EAC AUTOMATION-CONSULTING-GmbH, 14476 Neu Fahrland (DE)
(72) Erfinder: Wagner, Gerhard, Dipl.-Ing., D-13467 Berlin (DE)
(74) Vertreter: Christiansen, Henning, Dipl.-Ing.

(56) Entgegenhaltungen:
- EP-A- 0 415 439
- EP-A- 0 513 952
- DE-A- 3 639 430
- US-A- 3 746 981
- US-A- 5 025 344
- IEEE JOURNAL OF SOLID-STATE-CIRCUITS, Bd.27, Nr.3, März 1992, NEW YORK, US Seiten 425 - 428, XP000295899 MALY ET AL 'Built-in Current Testing'

## Beschreibung

Die Erfindung betrifft eine Einrichtung zur Störungserfassung für eine elektronische Baugruppe.

Aufgrund der sich ständig verringernden verwendeten Energiepegel bei informationsverarbeitenden Einrichtungen bei gleichzeitig engerer konstruktiver Integration von in ihrer Funktionalität ständig zunehmenden elektronischer Baugruppen und einem Zuwachs von Störungskomponenten, die u.a. aus höheren Kurzschlußstromstärken und Oberwellenanteilen resultieren, ist die elektromagnetische Verträglichkeit (EMV) einzelner Bauelemente bzw. Baugruppen sowie die Erfassung von möglichen Störungen zu einem wesentlichen Faktor bei komplexen elektronischen Anlagen geworden. Einrichtungen zur Störerfassung sind außerdem von Bedeutung, um bei einem aufgetretenen Störungsfall nachträglich die Ursache für den Ausfall einer Baugruppe ermitteln zu können. Insbesondere ist es wichtig, eine Aussage zu erhalten, ob als Ursache für den Störungszustand einer Baugruppe eine von außen in das System gelangte Störbeeinflussung in Betracht zu ziehen ist oder ob für den Störzustand der Ausfall eines Bauelements der Baugruppe verantwortlich gemacht werden kann.

In der industriellen Automatisierungstechnik und auch bei Datenverarbeitungsanlagen sind leitungsgeführte, von leitungsgebundenen und/oder leitungsungebundenen Störungen verursachte Störpegel eine der Hauptursachen für die Beeinflussung der elektromagnetischen Verträglichkeit von elektronischen Steuer- und Regelbaugruppen bzw. das Ausfallen für die Betriebsführung wesentlicher Anlagenteile.

Leitungsgebundene Störungen werden in bekannter Weise dadurch festgehalten, daß eine Sicherung anspricht und eine bleibende Leitungsunterbrechung bewirkt. Das Ansprechen der Sicherung bildet dabei gleichzeitig eine Störungsanzeige, verbunden mit einem Abschalten der entsprechend geschützten Baugruppe aus Sicherheitsgründen. Nach Beseitigung der Störungsursache wird dann die Sicherung ersetzt bzw. wiedereingeschaltet. Die Sicherung selbst gibt dabei indirekt Aufschluß über die Störungsursache.

Da Sicherungen gegen Überspannungen oder -ströme normalerweise mit einer Abschaltvorrichtung für die zu schützende Schaltung verbunden sind, geht die zu schützende Schaltung bei Ansprechen der Sicherung außer Betrieb - unabhängig davon, ob ein Schaden durch den Störungszustand eingetreten ist oder nicht. Eine derartige Art der "Störungsregistrierung" ist insoweit unzweckmäßig, als eine weitgehende Aufrechterhaltung des Betriebs bei solchen Störungen angestrebt wird, die nicht zu Ausfällen führen.

Ferner sind auch Registriergeräte für (ausschließlich leitungsgebundene) Störungen bekannt, welche - insbesondere im Bereich der Elektrizitätsversorgungsunternehmen - auf Leitungen auftretende Störspitzen fortlaufend registrieren, um bei eventuellen Ausfällen die Störungsursache eingrenzen zu können.

Wenn eine Einwirkung einer äußeren Störung auf die komplexen elektronischen Schaltungen der Baugruppen eines Systems über die zu diesen Baugruppen führenden Leitungen erfolgt, wird der mit der Störung verbundene Ausfall häufig zu einem Versicherungsfall. Ob dieses Störsignal aus dem Gerät selbst oder von außerhalb kam, ist aber bisher nachträglich nicht mehr feststellbar.

Insbesondere durch externe elektrostatische Entladungen oder Schaltvorgänge außerhalb des zu überwachenden Gerätes entstehen Störspannungen mit einem relativ breiten Spektrum, die leitungsgebunden übertragen werden. Eine solche Folge kurzer und steiler Impulse kann insbesondere in prozessorgesteuerten Abläufen zu Fehlfunktionen führen. Begrenzte Abhilfe schaffen zwar in der Regel Filter, deren Dämpfung dem Frequenzverlauf der Störspannung angepaßt ist. Bei prozessorgesteuerten Systemen können derartige Einflüsse jedoch nicht mit vollständiger Sicherheit ausgeschlossen werden, und durch äußere Störungen hervorgerufene Fehlsteuerungen können vielfach zu unvorhersehbaren Folgefehlern führen, deren Auswirkungen - einschließlich des so hervorgerufenen Schadens - im Einzelfall kaum abgeschätzt werden können.

Aus der DD-PS 279 083 ist eine Schaltungsanordnung bekannt, mit der eine Prüfung digitaler Baugruppen hinsichtlich ihrer elektromagnetischen Störfestigkeit vorgenommen werden kann. Hierbei wird der Takt- bzw. Setzeingang eines Flip-Flops, welches ein gleiches oder ähnliches Störverhalten wie die Bauelemente der zu überprüfenden Baugruppe aufweisen soll, mit einer galvanisch abgegriffenen, infolge elektromagnetischer Störbeeinflussung im Prüfling entstehenden Störspannung beschaltet.

Der wesentliche Nachteil der vorstehend beschriebenen Lösung besteht darin, daß die Reaktion des Flip-Flops auf mögliche Störimpulse gleichgesetzt wird mit der Störimpuls-Verträglichkeit von digitalen Schaltungen beliebiger Struktur. Damit sind (bis auf wenige Ausnahmen) Fehleinschätzungen verbunden, die zu erheblichen Geräteschäden führen können. Es kommt hinzu, daß die Störpotentiale über die räumliche Gerätediagonale abgegriffen werden, wodurch eine genauere Störungsanalyse wesentlich erschwert wird, und daß die Ansprechempfindlichkeit der Schaltung zur Störungsregistrierung unterhalb des zu einer Schädigung führenden Störpegels liegen muß, um eine Registrierung sicherzustellen.

Das unter Art. 54(3) EPÜ für die Vertragsstaaten AT, CH, LI, DE, FR, GB, IT und SE beachtliche Dokument EP-A-0 513 952 beschreibt eine Einrichtung zur Störungserfassung für eine elektronische Baugruppe und zum Festhalten einer deren Wirkungsweise beeinträchtigenden Störung zwecks nachträglicher Auswertung im Falle eines aufgetretenen Störzustandes, die zur Erfassung leitungsgebundener elektrischer und/oder leitungsungebundener elektrischer oder magnetischer Störungen mindestens ein Sensor/Speicher-Element, eine dem Sensor/Speicherelement vorgeschaltete Schwellwert-Schaltung und ein kapazitives oder induktives Koppelglied zwischen dem Eingang des Schwellwertgebers und einem Abschnitt eines Leitungszuges der elektronischen Baugruppe aufweist, wobei das Koppelglied, der Schwellwertgeber und das Sensor/Speicher-Element in räumlicher Zuordnung mit der elektronischen Baugrupe eine bauliche Einheit bilden.

Aus US-A-3 746 981 ist eine weitere Schaltung zur Störungserfassung für eine elektronische Baugruppe bekannt, deren wesentliche Funktionskomponenten mehrere, jeweils bestimmten Testpunkten zugeordnete Schwellwertdiskriminatoren und diesen nachgeschaltete Sensor/Speicher-Elemente sind. Die Schwellwertdiskriminatoren weisen Spannungsteilerschaltungen mit durch die Wahl zweier Widerstände fest vorgegebenem Teilungsverhältnis auf.

Aus US-A-0 525 344 ist ein auf einem gemeinsamen Substrat mit einer integrierte Schaltung zu realisierender Stromsensor bekannt, mit dem anormale Ruheströme durch die integrierte Schaltung und damit insbesondere Kurzschlüsse oder Leitungsunterbrechungen erfaßt werden können.

Ausgehend von den Mängeln des Standes der Technik, liegt der Erfindung die Aufgabe zugrunde, eine Einrichtung zur Störungserfassung zu schaffen, die es bei leitungsgeführten, von leitungsgebundenen und/oder leitungsungebundenen Störungen hervorgerufenen Störsignalen ermöglicht, nach einem aufgetretenen Störfall eine genauere Aussage sowohl über die Amplitude des Störsignals als auch über dessen mögliche Ursache zu treffen.

Die vorgenannte Aufgabe wird mit den Merkmalen des Anspruchs 1 gelöst.

Die Erfindung geht aus von der Erkenntnis, daß die überwiegende Anzahl von leitungsgebunden und leitungsungebunden vorhandenen Störungen, die die elektromagnetische Verträglichkeit zwischen verschiedenen elektrischen oder elektronischen Baugruppen von Geräten beeinträchtigen, als Störpegel durch Leitungen auf die Baugruppen übertragen werden. Gleichermaßen ist zu beachten, daß für eine beweissichernde Störerfassung eine feste Zuordnung zwischen Einrichtung zur Störüberwachung und zu überwachender Baugruppe von besonderem Vorteil ist. Damit ist sichergestellt, daß auf den Ort und die Art der Störung jederzeit auch noch nachträglich geschlossen werden kann.

Bei der erfindungsgemäßen Lösung ist von besonderer Bedeutung, daß eine erkannte und registrierte Störung nicht von der weiteren Signalverarbeitung durch die elektronische Schaltung der zu überwachenden Baugruppe nachträglich verändert wird. Da die Baugruppe mit großer Wahrscheinlichkeit durch die Störung in ihrer Arbeitsweise beeinträchtigt ist, würde mit großer Wahrscheinlichkeit auch die Störmeldung fehlerhaft behandelt werden, so daß deren Zuverlässigkeit in Frage gestellt ist. Bei der bevorzugten Ausführungsform der Erfindung erfolgt die Erfassung einer leitungsgebundenen Störung an einer Eingangsleitung der zu überwachenden elektronischen Baugruppe. Die Ankopplung der Einrichtung zur Störerfassung wird bei fester räumlicher Zuordnung zu der Baugruppe auf engstem Raum vorgenommen, um eine Verfälschung des erfaßten Störpegels auf ein Minimum herabzusetzen. Die Verwendung einer Schwellwert-Schaltung sichert in vorteilhafter Weise eine Pegelüberwachung auf der Eingangsleitung, so daß jede Störung, die zu einer Überschreitung des Logikpegels führt, erfaßt und lokal zugeordnet werden kann.

Entsprechend der Erfindung wird der Anschluß der Einrichtung zur Störerfassung mit der Eingangsleitung einer zu überwachenden Baugruppe durch eine nichtgalvanische Verbindung hergestellt. Eine kapazitive oder induktive Kopplung verhindert in günstiger Weise eine Verfälschung des normalen Logikpegels und läßt darüberhinaus auch einen Betrieb an potentialgetrennten Systemen zu.

Die dem Sensor/Speicher-Element erfindungsgemäß vorgeordnete Schwellwert-Schaltungsweist mehrere Spannungsteiler auf. Das einstellbare bzw. vorprogrammierbare Teilungsverhältnis der mehreren, parallel geschalteten Spannungsteiler ermöglicht auf einfache Weise eine Realisierung unterschiedlicher, von den Störungen verursachte Potentiale, die an entsprechende Ansprechempfindlichkeiten der den jeweiligen Spannungsteilern nachgeordneten, speicherfähigen Detektier-Einrichtungen, vorzugsweise bistabiler Kippschaltungen, angepaßt sind. In.verbindung mit einer zusätzlichen Auswerte-Einheit, z.B. einem Mikrorechner, in welche die von den Sensor/Speicher-Elementen detektierten Störungen eingespeist werden, sind somit unterschiedlich starke Störpegel vergleichbar und können möglichen Störfällen zugeordnet werden.

Vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
Figur 1 den grundsätzlichen Aufbau der bevorzugten Ausführungsform der Erfindung in schematisierter Darstellung,
Figur 2 ein Detail einer vorteilhaften Ausführungsform der Erfindung im Blockschaltbild,
Figur 3 eine günstige Weiterbildung der in Figur 2 gezeigten Ausführungsform der Erfindung in schematischer Darstellung,
Figur 4 ein Detail einer anderen vorteilhaften Ausführungsform der Erfindung als Blockschaltbild,
Figur 5 die perspektivische Darstellung einer erfindungsgemäß ausgerüsteten elektronischen Baugruppe,
Figuren 6 und 7 weitere vorteilhafte Ausführungen der Einzelheit A gemäß Figur 5 in schematisierter Darstellung sowie
Figur 8 eine günstige Weiterbildung der Einzelheit A gemäß Figur 5 in schematisierter Darstellung.

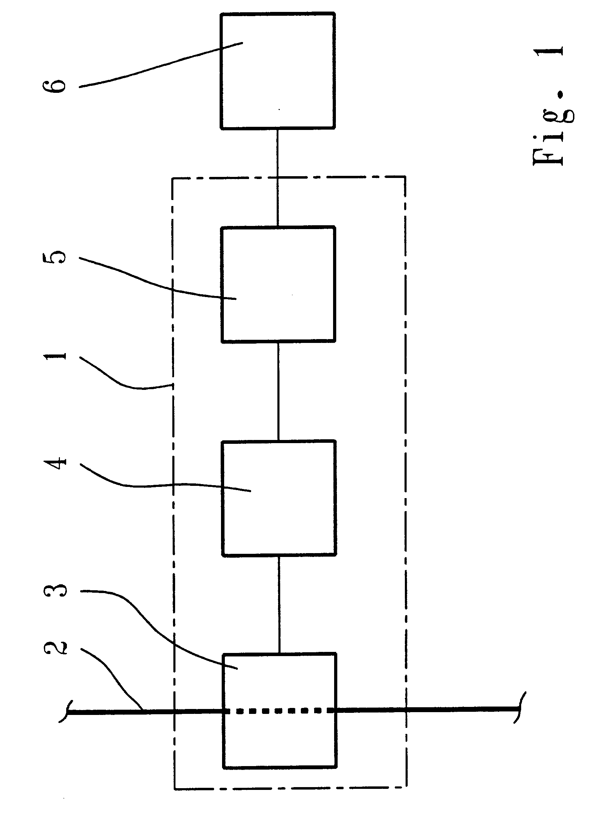

Die in Figur 1 als Blockschaltbild dargestellte Einrichtung zur Störerfassung 1 ist durch ein Koppelglied 3 mit einem Leitungszug 2 einer hinsichtlich von leitungsgebunden und/oder leitungsungebunden auftretenden Störungen zu überwachenden elektronischen Schaltung verbunden. Die durch die Ankopplung an die Leitung 2 auf eine Schwellwert-Schaltung übertragenen, einer Störung entsprechenden Spannungswerte werden einem Sensor-/Speicher-Element 5 zugeleitet und dort geeignet detektiert. Die Erfassung und Bewertung von festgestellten Störungsereignissen erfolgt in vorteilhafter Weise rechnergestützt in einer dem Sensor/Speicher-Element 5 nachgeschalteten Auswerte-Einheit 6.

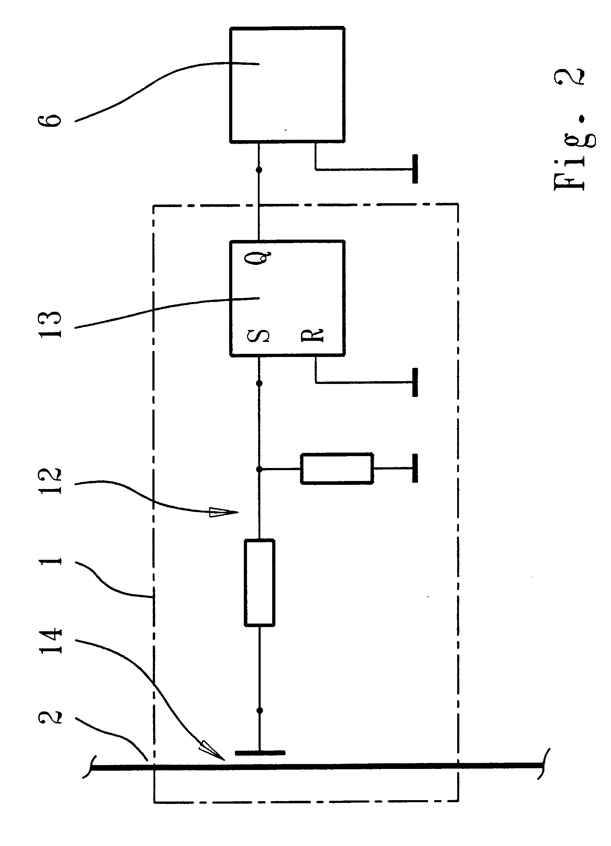

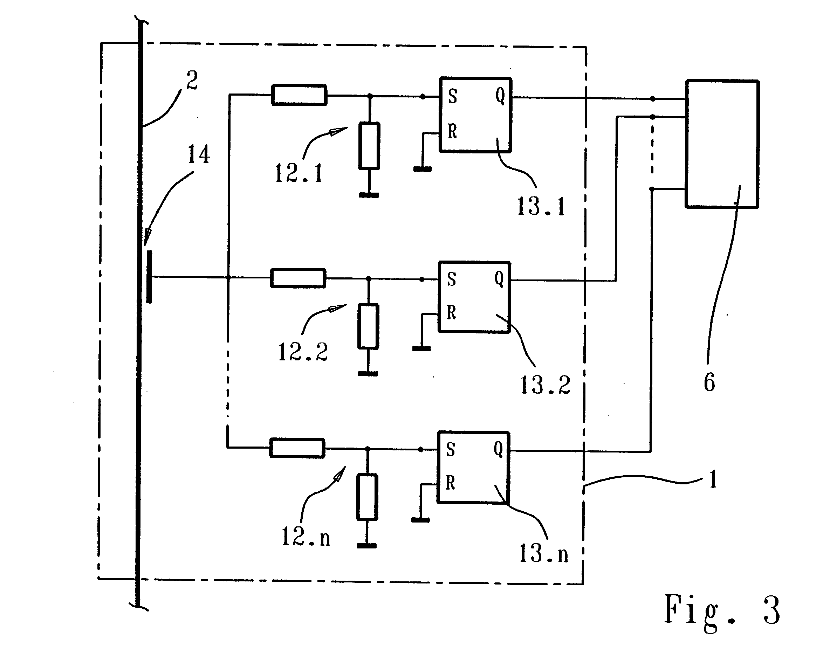

Die Wirkungsbeziehung zwischen dem Leitungszug 2 und der Einrichtung zur Störungserfassung 1 wird entsprechend dem in Figur 2 schematisiert dargestellten Schaltbild durch eine kapazitive Koppelstelle 14 realisiert, wobei ein Abschnitt des Leitungszuges 2 eine der Elektroden des Kondensators der Koppelstelle bildet. Die Schwellwert-Schaltung (Position 4 in Figur 1) ist als Spannungsteiler 12 ausgebildet, dessen Teilungsverhältnis der Ansprechschwelle am Setzeingang S der bistabilen Kippstufe 13 angepaßt ist. Die von der bistabilen Kippstufe 13, vorzugsweise einem Flip-Flop, detektierten und befristet gespeicherten Störungszustände werden am Signalausgang Q der bistabilen Kippstufe 13 durch die Auswerte-Einheit 6 erfaßt und weiterverarbeitet (z.B. Bezug zu Vergleichswerten bekannter Störereignisse und Registrierung der Störamplituden) Figur 3 zeigt eine günstige Ausführung der vorstehend beschriebenen Einrichtung zur Störungserfassung 1. Der Schwellwertgeber (Postion 4 in Figur 1) besteht aus einer Mehrzahl von Spannungsteilern 12.1 bis 12.n, die jeweils ein voneinander verschiedenes Teilungsverhältnis besitzen. Jeder der Spannungsteiler 12.1 bis 12.n ist einer bistabilen Kippstufe 13.1 bis 13.n zugeordnet, deren Ansprechempfindlichkeit an das Teilungsverhältnis der jeweiligen Spannungsteiler angepaßt ist. Dadurch ist es in günstiger Weise möglich, an einer Stelle der zu überwachenden elektronischen Baugruppe Störungen unterschiedlicher Stärke getrennt zu detektieren und auszuwerten. Je nach Schwere der Störungen kann dabei unterschieden werden zwischen
- Überschreiten der Normforderungen nach IEC 801
   und
- Gefährdung der Daten- und/oder Betriebssicherheit.

Die Ankopplung 14 an einen der Leitungszüge 2 der elektronischen Baugruppe erfolgt ebenfalls kapazitiv. Diese kapazitive Ankopplung einer Einrichtung 1 zur Störungserfassung kann an verschiedenen Punkten der elektronischen Baugruppe gleichzeitig vorgenommen werden und ermöglicht zugleich - bei geeigneter Dimensionierung der Kapazität des verwendeten Koppelkondensators - einen Betrieb an potentialgetrennten Systemen.

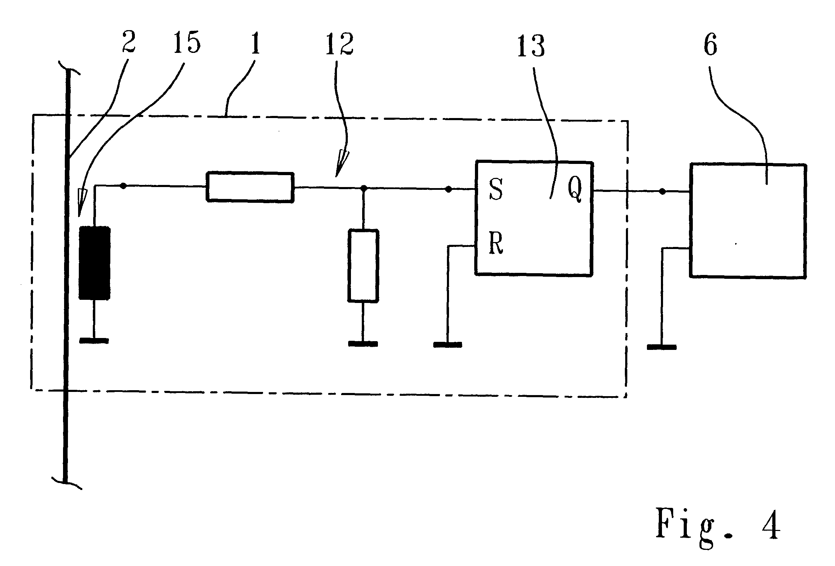

Die in Figur 4 als Schaltbild dargestellte Einrichtung zur Störungserfassung 1 besitzt eine induktive Koppelstelle 15 zur Ankopplung des Spannungsteilers 12. Die Kopplungsstelle 15 ist in günstiger Weise als Transformator ausgebildet, wobei die Leitung 2 die Primärwicklung des Transformators bildet. Die Wirkungsweise der restlichen Schaltung entspricht den vorstehend gemachten Ausführungen.

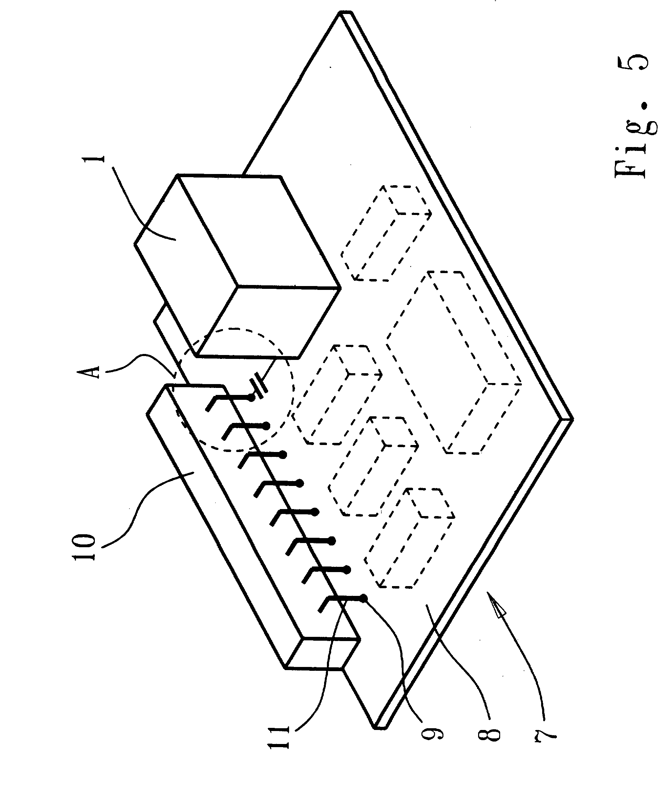

Figur 5 zeigt eine zu überwachende elektronische Baugruppe 7 mit der dazugehörigen Einrichtung 1 zur Störungserfassung schematisch in perspektivischer Darstellung. Die Einrichtung 1 zur Störungserfassung ist auf der Leiterplatte 8 in unmittelbarer Nähe des Steckers 10 angeordnet. Die Einzelheit A erfaßt den Bereich der Koppelstelle, die sich direkt am Steckerpin 11 bzw. an dem dazugehörigen Lötauge 9 eines Leitungszuges, vorzugsweise einer Eingangsleitung der elektronischen Baugruppe 7, auf der Leiterplatte 8 befindet. Die Elemente 3, 4, 5 der Einrichtung 1 bilden so bei engster räumlicher Zuordnung mit der elektronischen Baugruppe 7 eine bauliche Einheit.

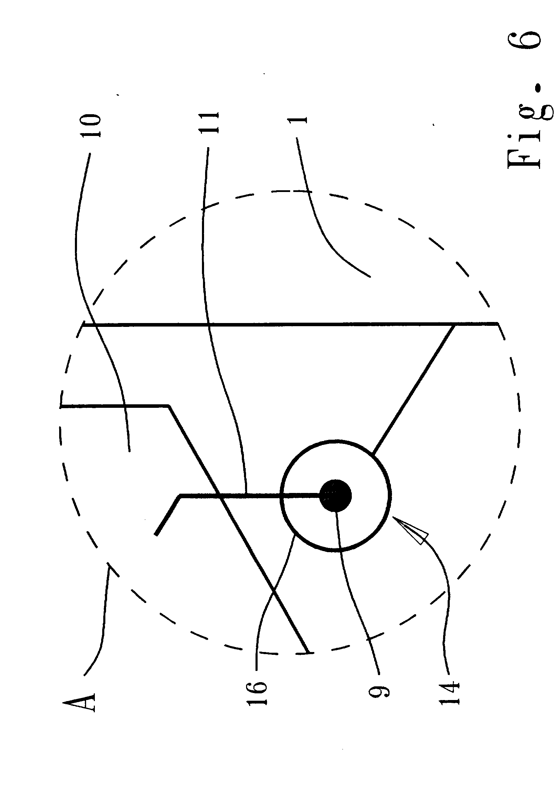

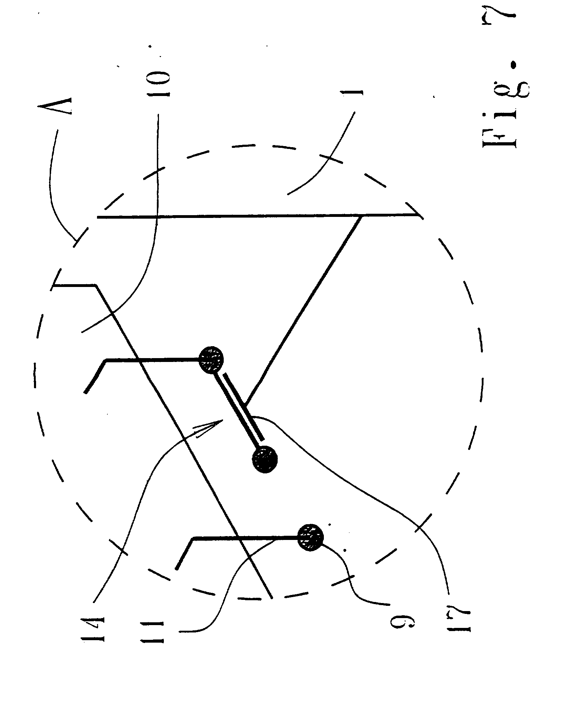

Die Figuren 6, 7 und 8 zeigen als Vergrößerung der Einzelheit A in Figur 5 in schematisierter Darstellung verschiedene Ausführungsformen der Koppelstellen 14 und 15 der Einrichtung 1 zur Störungserfassung, bei deren Bildung in vorteilhafter Weise ein Abschnitt einer Leitung der zu überwachenden elektronischen Baugruppe einbezogen wird. Figur 6 zeigt eine kapazitive Koppelstelle 14, deren Kondensator aus einer das Lötauge 9 des Steckerpins 11 ringförmig umschließenden Elektrode 16 und einer aus dem Steckerpin 11 gebildeten Stabelektrode besteht. Der aus dem Stecker 10 herausgeführte Steckerpin 11 ist vorzugsweise mit einer Eingangsleitung der elektronischen Baugruppe verbunden. Die Kapazität der Kopplungsstelle 14 kann in einfacher Weise auch aus zwei parallel und dicht nebeneinander angeordneten Leitungszügen 17 gebildet werden, von denen einer einen Abschnitt der Eingangsleitung der elektronischen Baugruppe verkörpert, wie in Figur 7 schematisiert dargestellt ist.

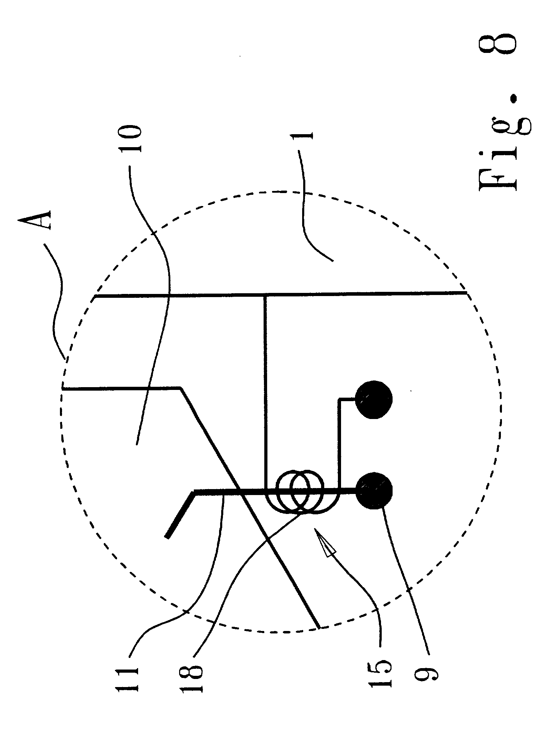

Figur 8 zeigt ein Ausführungsbeispiel einer induktiven Ankopplung 15 der Einrichtung zur Störungserfassung 1 an eine Leitung der elektronischen Baugruppe. Die Koppelstelle 15 besteht aus einem Transformator, dessen Primärwicklung aus dem Steckerpin 11 gebildet wird. Die Störungsamplituden werden durch Induktion auf die Sekundärwicklung 18 übertragen und können danach in der Einrichtung zur Störungserfassung 1, wie vorab erläutert, weiterverarbeitet werden. Zur Vermeidung von Kurzschlüssen ist zwischen Steckerpin 11 und der ihn umgebenden Sekundärwicklung 18 eine (nicht dargestellte) Isolation vorgesehen.

## Patentansprüche

1. Einrichtung zur Störungserfassung für eine elektronische Baugruppe (7) und zum Festhalten einer die Wirkungsweise der elektronischen Baugruppe (7) beeinträchtigenden Störung zwecks nachträglicher Auswertung im Falle eines in dieser Baugruppe aufgetretenen Störzustandes, die zur Erfassung leitungsgebundener elektrischer und/oder leitungsungebundener elektrischer oder magnetischer Störungen
- mindestens ein Sensor/Speicher-Element (5),
- eine dem Sensor/Speicher-Element (5) vorgeschaltete Schwellwert-Schaltung (4)
und
- ein kapazitives oder induktives Koppelglied (3) zwischen dem Eingang der Schwellwert-Schaltung (4) und einem Abschnitt eines Leitungszuges (2) der elektronischen Baugruppe (7)
aufweist, wobei
das Koppelglied (3), die Schwellwert-Schaltung (4) und das Sensor/Speicher-Element (5) in räumlicher Zuordnung mit der elektronischen Baugruppe (7) eine bauliche Einheit bilden und
die Schwellwert-Schaltung (4) eine Mehrzahl parallelgeschalteter Spannungsteiler (12.1 bis 12.n) mit unterschiedlichem Teilerverhältnis aufweist.

2. Einrichtung zur Störungserfassung nach Anspruch 1, **dadurch gekennzeichnet,** daß das Koppelglied (3) als Kondensator ausgebildet ist, wobei die erste Elektrode durch einen Abschnitt eines Leitungszugs (2) der elektronischen Baugruppe (7) gebildet wird und die zweite Elektrode (16) den Abschnitt des Leitungszuges (2) ringförmig umgibt.

3. Einrichtung zur Störungserfassung nach Anspruch 2, **dadurch gekennzeichnet,** daß die zweite Elektrode (17) des Kondensators im wesentlichen parallel zu dem Leitungszug (2) der elektronischen Baugruppe (7) verläuft.

4. Einrichtung zur Störungserfassung nach einem der Ansprüche 1 bis 3, **dadurch gekennzeichnet,** daß als Sensor/Speicher-Element (5) eine bistabile Kippstufe (13) vorgesehen ist.

5. Einrichtung zur Störungserfassung nach einem der vorangehenden Ansprüche, **dadurch gekennzeichnet,** daß jedem Spannungsteiler (12.1 bis 12n) ein Sensor/Speicher-Element (13.1 bis 13.n) mit einer dem Teilerverhältnis angepaßten Ansprechschwelle zugeordnet ist.

6. Einrichtung zur Störungserfassung nach einem der vorangehenden Ansprüche, **dadurch gekennzeichnet,** daß die Ausgänge der Sensor/Speicher-Elemente (5) mit einer Auswerte-Einrichtung (6) verbunden sind.

7. Einrichtung zur Störungserfassung nach Anspruch 6, **dadurch gekennzeichnet,** daß als Auswerte-Einrichtung (6) ein Mikrorechner vorgesehen ist.

8. Einrichtung zur Störungserfassung nach einem der vorangehenden Ansprüche, **dadurch gekennzeichnet,** daß das Koppelglied (3) einen Transformator aufweist, dessen Primarwicklung durch einen Abschnitt des Leitungszugs (2) der elektronischen Baugruppe (7) gebildet wird und dessen Sekundärwicklung (18) mit der Schwellwert-Schaltung (4) verbunden ist.

9. Einrichtung zur Störungserfassung nach Anspruch 8, **dadurch gekennzeichnet,** daß die Sekundärwicklung (18) den Leitungszug (2) konzentrisch umschließt.

10. Einrichtung zur Störungserfassung nach einem der vorangehenden Ansprüche, **dadurch gekennzeichnet,** daß das Koppelglied (3) einer Ein- oder Ausgangsleitung der elektronischen Baugruppe (7) räumlich zugeordnet ist.

## Claims

1. Disturbance detection device for an electronic assembly (7) and for retaining a disturbance impairing the operating mode of the electronic assembly (7) for the purpose of subsequent evaluation in the case of a disturbance state occurring in this assembly, which device, in order to detect conducted electrical and/or non-conducted electrical or magnetic disturbances, comprises
- at least one sensor/memory element (5),
- a threshold circuit (4) connected upstream of the sensor/memory element (5)
and
- a capacitive or inductive coupling member (3) between the input of the threshold circuit (4) and a section of a conductor run (2) of the electronic assembly (7),
wherein
the coupling member (3), the threshold circuit (4) and the sensor/memory element (5) form a structural unit in a spatial association with the electronic assembly (7) and
the threshold circuit (4) comprises a plurality of parallel-connected voltage dividers (12.1 to 12.n) with different divider ratios.

2. Disturbance detection device according to claim 1, characterised in that the coupling member (3) is constructed as a capacitor, wherein the first electrode is formed by a section of a conductor run (2) of the electronic assembly (7) and the second electrode (16) surrounds the section of the conductor run (2) in the shape of a ring.

3. Disturbance detection device according to claim 2, characterised in that the second electrode (17) of the capacitor extends substantially parallel to the conductor run (2) of the electronic assembly (7).

4. Disturbance detection device according to any one of claims 1 to 3, characterised in that a bistable toggle stage (13) is provided as the sensor/memory element (5).

5. Disturbance detection device according to any one of the preceding claims, characterised in that a sensor/memory element (13.1 to 13.n) with a response threshold adapted to the divider ratio is associated with each voltage divider (12.1 to 12.n).

6. Disturbance detection device according to any one of the preceding claims, characterised in that the outputs of the sensor/memory elements (5) are connected to an evaluation device (6).

7. Disturbance detection device according to claim 6, characterised in that a microcomputer is provided as the evaluation device (6).

8. Disturbance detection device according to any one of the preceding claims, characterised in that the coupling member (3) comprises a transformer whose primary winding is formed by a section of the conductor run (2) of the electronic assembly (7) and whose secondary winding (18) is connected to the threshold circuit (4).

9. Disturbance detection device according to claim 8, characterised in that the secondary winding (18) concentrically surrounds the conductor run (2).

10. Disturbance detection device according to any one of the preceding claims, characterised in that the coupling member (3) is spatially associated with an input or output line of the electronic assembly (7).

## Revendications

1. Dispositif de saisie de perturbations pour un ensemble électronique (7) et de maintien d'une perturbation altérant le mode opératoire de l'ensemble électronique (7) en vue d'une évaluation ultérieure dans le cas d'un état de panne survenu dans cet ensemble, qui comporte en vue de la saisie de perturbations électriques liées aux lignes et/ou de perturbations électriques ou magnétiques non liées aux lignes
- au moins un capteur doué de mémoire (5),
- un circuit à valeur de seuil (4) disposé en amont du capteur doué de mémoire (5), et
- un élément de couplage capacitif ou inductif (3) entre l'entrée du circuit à valeur de seuil (4) et un tronçon d'une ligne (2) de l'ensemble électronique (7),
l'élément de couplage (3), le circuit à valeur de seuil (4) et le capteur doué de mémoire (5) associés spatialement à l'ensemble électronique (7) formant une unité structurale, et
le circuit à valeur de seuil (4) présentant une pluralité de diviseurs de tension (12.1 à 12.n) montés en parallèle avec des rapports de division différents.

2. Dispositif de saisie de perturbations selon la revendication 1, caractérisé en ce que l'élément de couplage (3) est réalisé sous la forme d'un condensateur, la première électrode étant formée par un tronçon d'une ligne (2) de l'ensemble électronique (7) et la seconde électrode (16) entourant annulairement le troncon de la ligne (2).

3. Dispositif de saisie de perturbations selon la revendication 2, caractérisé en ce que la seconde électrode (17) du condensateur s'étend sensiblement parallèlement à la ligne (2) de l'ensemble électronique (7).

4. Dispositif de saisie de perturbations selon l'une quelconque des revendications 1 à 3, caractérisé en ce qu'une bascule bistable (13) est prévue en tant que capteur doué de mémoire (5).

5. Dispositif de saisie de perturbations selon l'une quelconque des revendications précédentes, caractérisé en ce qu'à chaque diviseur de tension (12.1 à 12.n) est associé un capteur doué de mémoire (13.1 à 13.n) avec un seuil de réponse adapté au rapport du diviseur.

6. Dispositif de saisie de perturbations selon l'une quelconque des revendications précédentes, caractérisé en ce que les sorties des capteurs doués de mémoire (5) sont reliées à un dispositif d'évaluation (6).

7. Dispositif de saisie de perturbations selon la revendication 6, caractérisé en ce qu'un microcalculateur est prévu en tant que dispositif d'évaluation (6).

8. Dispositif de saisie de perturbations selon l'une quelconque des revendications précédentes, caractérisé en ce que l'élément de couplage (3) comporte un transformateur dont l'enroulement primaire est formé par un tronçon de la ligne (2) de l'ensemble électronique (7) et dont l'enroulement secondaire (18) est relié au circuit à valeur de seuil (4).

9. Dispositif de saisie de perturbations selon la revendication 8, caractérisé en ce que l'enroulement secondaire (18) entoure concentriquement la ligne (2).

10. Dispositif de saisie de perturbations selon l'une quelconque des revendications précédentes, caractérisé en ce que l'élément de couplage (3) est associé spatialement à une ligne d'entrée ou de sortie de l'ensemble électronique (7).
